Europäisches Patentamt

European Patent Office

Office européen des brevets

⑩

(11) Publication number: **0 195 145**
**B1**

# EUROPEAN PATENT SPECIFICATION

(12)

(45) Date of publication of patent specification: **13.06.90**

(21) Application number: **85301880.2**

(22) Date of filing: **18.03.85**

(51) Int. Cl.⁵: **H 05 K 7/14**

(54) **Cassette connector.**

(43) Date of publication of application:
**24.09.86 Bulletin 86/39**

(45) Publication of the grant of the patent:
**13.06.90 Bulletin 90/24**

(84) Designated Contracting States:
**BE CH DE FR GB IT LI NL SE**

(56) References cited:
**EP-A-0 082 774**
**US-A-4 185 882**

(73) Proprietor: **THOMAS & BETTS CORPORATION**
**920 Route 202**
**Raritan New Jersey 08869 (US)**

(72) Inventor: **Sonobe, Toshimitsu**
**2-15-5 Todoroki Setagaya-Ku**
**Tokyo 158 (JP)**

(74) Representative: **Howick, Nicholas Keith et al**
**CARPMAELS & RANSFORD 43 Bloomsbury**
**Square**
**London WC1A 2RA (GB)**

## Description

### Field of the invention

The present invention relates to an electrical connector and, more particularly, to an electrical connector for connecting cassettes which are detachable therefrom.

From EP—A—0082774 there is known a cassette-type magnetic-bubble memory apparatus having a holder which comprises a molded plastic housing, a bracket including a connector and a molded plastic case for receiving a cassette, the housing further having an opening for inserting the cassette into the holder and a pin disposed at either sides on both the right side and the left side of the opening, said pin fitting into an L-shaped guide groove formed on each side surface of the cassette when the cassette is inserted into the holder by sliding the guide grooves over the pins.

In an electronic musical instrument having a keyboard, for example, a memory cassette is provided which stores rhythm accompaniment data. A player may replace a rhythm cassette with another to select a desired rhythm.

A cassette and a connector therefor installed in such a musical instrument unit have a structure for holding the cassette therein and in addition for making an electrical connection therewith in the same manner as an electrical connection to a printed circuit board (PCB). When the cassette is repeatedly inserted to make engagement with the connector, incomplete electrical connections can often occur, thereby presenting problems.

### Summary of the invention

The primary object of the present invention as claimed is to provide an electrical connector that overcomes the deficiencies of prior art devices.

In accordance with a more particular aspect of the present invention, a cassette and an electrical connector which may be in a musical instrument unit are joined independently of the electrical connection between terminals of the cassette and such connector in the musical instrument unit. As such, desirable electrical connections are provided even where the terminals of the cassette are frequently inserted in or detached from the connector, thereby eliminating the above-mentioned problems.

The present invention is described hereinafter with reference to an embodiment in conjunction with the accompanying drawings.

### Brief description of the drawings

Figures 1A and 1B are side and front elevation views, respectively, showing a connected state between a connector and a cassette in accordance with a preferred embodiment of the invention.

Figure 2 is an exploded perspective view of the connector housing.

Figure 3 is an exploded perspective view of a cassette package in accordance with a preferred arrangement.

Figure 4 is an illustration showing the connection procedures between the connector housing and the cassette.

Figure 5 is a sectional view as seen along the lines V—V of Figure 2 showing a state wherein the cassette is mounted in the housing.

Figure 6 is a partial cutaway perspective view of a cassette according to another embodiment of the present invention.

Figure 7 is a partial cutaway view of the connector housing adapted to connect to the cassette of Figure 6.

Figure 8 is a sectional view showing a state wherein the cassette of Figure 6 is mounted in the housing of Figure 7.

Figure 9 is a partial cutaway perspective view of a cassette according to still another embodiment of the present invention.

Figure 10 is a partial cutaway perspective view of the connector housing adapted to connect to the cassette of Figure 9.

Figure 11 is a sectional view showing a state wherein the cassette of Figure 9 is mounted in the housing of Figure 10.

### Detailed description of the preferred embodiments

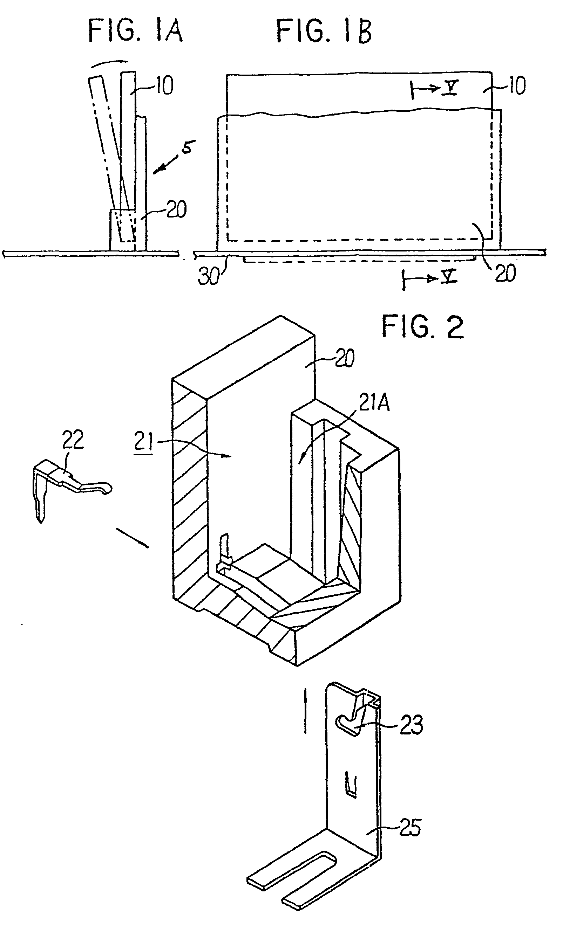

Referring now to the Figures 1A and 1B, a connector 5 comprises a housing 20 for detachably receiving and holding a cassette 10, the housing 20 being mounted on a printed circuit board 30. The cassette 10 is obliquely inserted in the housing 20 and is pivoted and locked in a manner to be described in detail. As used herein, the term cassette is intended to mean a package containing the storage of retrievable information and, which, in the preferred form, includes a plurality of individual electrical terminals that are exteriorly accessible and which interiorly are in electrical connection to devices containing the stored information. A connector for receipt of such a cassette 5 may be provided in a variety of devices, such as a musical instrument unit (not shown) that are adapted to be responsive to the data stored in such cassettes.

Figure 2 is a cutaway exploded view of the housing 20 to illustrate the internal structure thereof. The housing 20 comprises, for example, a glass fiber reinforced resin or other suitable material. A cassette insertion port 21A of a hollow portion 21 has a width which is gradually increased outwardly from the bottom of portion 21. More particularly, the hollow portion 21 is formed to allow oblique insertion of the cassette 10 into the cassette insertion port 21A, (as shown in phantom in Figure 1A). When the cassette 10 is pivoted to be substantially perpendicular (as shown in the solid lines in Figure 1A) to the cassette insertion port 21A, a latch holds the cassette 10, as will be described.

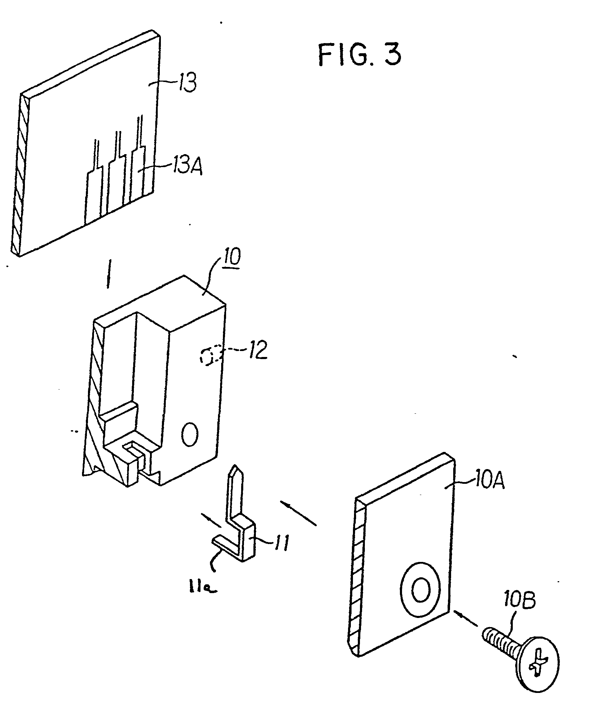

An electrical contact 22 in the housing 20 comprises a leaf spring which is securely mounted in the bottom of the hollow portion 21. When the cassette 10 is mounted in the hollow portion 21, the contact 22 is brought into contact with a selected terminal 11 (Figure 3) of the cassette, thereby making electrical connection therewith, as will be detailed. Reference numeral 25 denotes an L-shaped latch plate, the material of which is preferably a spring-like metal. The latch plate 25 has a slot 23 for receiving a latch pin of the cassette 10. The latch plate 25 is mounted on the side surface of the housing 20. The slot 23 has a guide function for guiding the cassette 10 into the housing 20 and a locking function for locking the latch pin. The slot 23 is generally L-shaped.

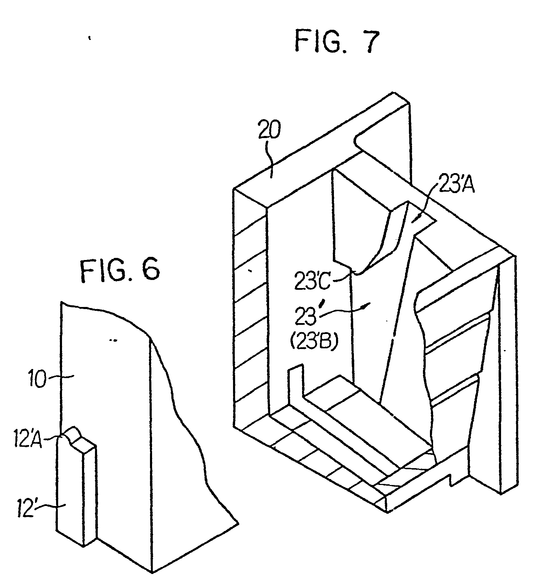

As illustrated in the exploded view of Figure 3, a printed circuit board 13 is mounted to the cassette 10. Reference numerals 10A and 10B denote, respectively, a cassette cover and a screw for fastening the cassette cover 10A to the cassette housing 10. Each of the conductors 13A of the printed circuit board 13 is exposed exteriorly of the cassette so as to electrically connect to the corresponding terminal 11 (Figure 5). Terminal 11 is supported in the cassette so as to have a portion 11a disposed for exterior access so as to allow for connection with housing contact 22 when the cassette and housing are joined. A latch pin 12 projects outwardly from an outer portion of the side surface of the cassette 10. The latch pin 12 holds the cassette in the housing 20 during insertion of the cassette into the housing 20.

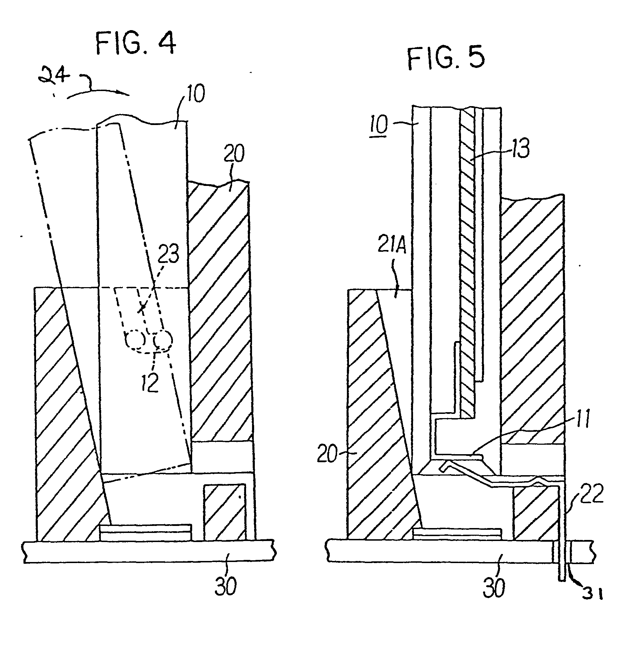

As shown in Figure 4, the cassette 10 is obliquely inserted into the housing 20 so that the latch pin 12 of the cassette 10 is engaged with the slot 23 of plate 25 supported by the housing 20. In this manner, the orientation of the cassette 10 is not determined by the inclination of the hollow portion 21, but rather by the guide (slot) 23. As such, when the cassette 10 is obliquely inserted into the housing 21 along the guide 23 and is pivoted in the direction as indicated by the arrow 24, the latch pin 12 is engaged initially with the top of slot 23, and then with continued insertion with the foot portion of the slot, thereby mounting the cassette 10 securely in the housing 20.

In Figure 5 the contact 22 is shown mounted through the through aperture 31 of the printed circuit board 30 and is preferably soldered thereto.

Another embodiment of the present invention is described with reference to Figures 6 to 8.

The latch means of this embodiment comprises a projection 12′ formed on the side wall of the cassette 10, and a recess 23′ formed in the inner wall surface of the hollow portion of the housing to engage with the projection 12′. The recess comprises a guide groove 23′A for guiding oblique insertion of the cassette into the insertion port and a locking groove 23′B for locking the projection when the cassette is pivoted to be perpendicular to the insertion port. Reference numeral 12′A in Figure 6 and reference numeral 23′C in Figure 7 denote engaging projections, respectively, each of which provide cooperative engagement between the projection and the locking groove.

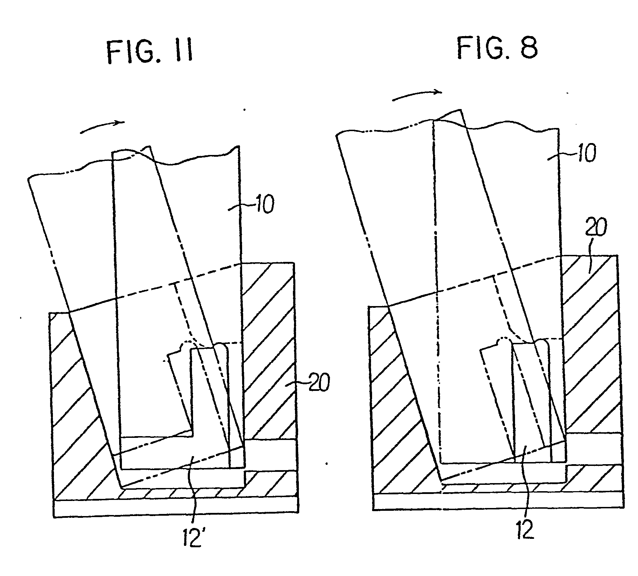

Figure 8 shows a state wherein the cassettte 10 is mounted in the housing in accordance with this second embodiment.

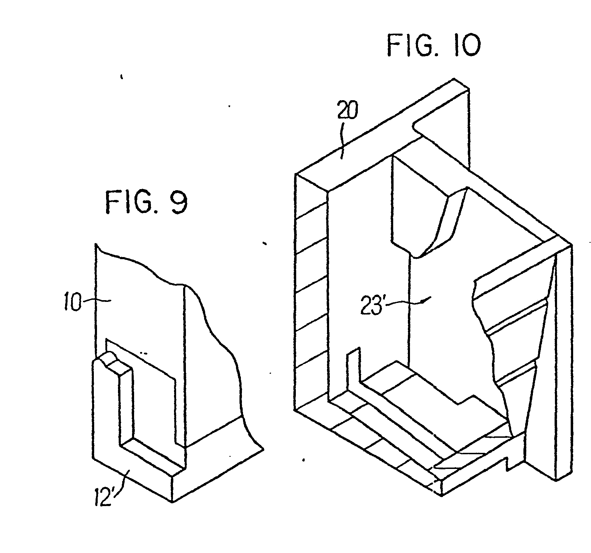

Figures 9 to 11 show a third embodiment of the present invention. According to this embodiment with further reference to the second embodiment, the projection of the cassette is formed preferably in an L-shape, and the housing recess is enlarged to accommodahe and engage with the L-shaped projection. Figure 11 depicts a state wherein the cassette is mounted in the housing in this third embodiment. According to the third embodiment as compared with the first and second embodiments, the latching means (projection) of the cassette side and the latching means (groove) of the housing firmly mesh with each other so as to provide a polarization feature thereby preventing reverse side insertion of the cassette. As the cassette connector according to the present invention has the construction as described hereinabove, the following advantages are provided. Since the holding means mechanically holds the cassette and the housing together, the cassette need not be held by the means for electrically connecting the cassette and the housing. In addition, the cassette and the contact 22 of the housing are connected with each other through a leaf spring so as to withstand frequent connection operation of the cassette.

In order to mount the cassette in the housing, the cassette is obliquely inserted and is pivoted, so that the spring contact is brought into slidable contact with the cassette but not into point contact. In this sense, even if the cassette terminals become soiled or contaminated they can be cleaned through the sliding action, thus preventing poor connections.

Having described the preferred embodiments of the invention herein, it should be appreciated that various modifications may be made. For example, it should be understood that while the connector in the preferred arrangement is adapted for connection to a cassette, the electrical connector of the present invention is not so restricted and may be used to make connections with other electrical components, such as printed circuit boards.

**Claims**

1. An electrical connector assembly comprising:
   a cassette (10) having a plurality of exteriorly accessible electrical terminals (11) and including a generally L-shaped projection (12′) extending outwardly from a portion of said cassette, a ridge (12′A) being disposed adjacent the top portion of said L-shaped projection; and
   an electrical connector including a housing (20) for secured receipt of said cassette, said housing having a cavity therein for receipt of said cassette and a plurality of electrical spring contacts (22) disposed in said housing cavity and arranged therein to engage the terminals (11) of said cassette upon insertion of said cassette therein, said housing having a recess (23′) in an inside wall defining said cavity, said recess being sized to receivingly accommodate the foot portion of said L-shaped projection, said housing having a latching member (23'B, 23'C) for latchingly engaging said ridge on said L-shaped projection, when said cassette is inserted on said connector.

2. An electrical connector assembly as claimed in Claim 1, wherein said cavity has an opening which is gradually increased in dimension from the bottom of the cavity.

3. An electrical connector assembly as claimed in Claim 1 or Claim 2, wherein said cavity is shaped to receive said cassette obliquely into said cavity and wherein the latching engagement is effected upon movement of said cassette into a position such that two major substantially parallel opposing walls of the cassette are perpendicular to the bottom inner surface of said cavity.

4. An electrical connector assembly as claimed in Claim 3, wherein said recess comprises a guide groove (23'A) for inserting the cassette obliquely into said cavity and a mate groove (23'B) for latching said ridge upon movement of said cassette into a position such that two major substantially parallel opposing walls of the cassette are perpendicular to the bottom inner surface of said cavity.

5. An electrical connector assembly comprising:

a cassette (10) having two major substantially parallel opposing walls spaced by a given spacing, a bottom wall extending transversely between said two major walls and a plurality of electrical terminals (11) contained within said cassette that are exteriorly accessible through said bottom wall, and a latching element (12, 12', 12'A) on said cassette; and

an electrical connector (5) for secured receipt of said cassette, said connector including a housing (20), the housing having a back surface, a front surface spaced from said back surface and a bottom surface, said back, front and bottom surfaces defining a cavity for receipt of said cassette, said front surface and said back surface converging toward each other and defining thereby an opening at the upper portion of said cavity that is wider than the given spacing of said cassette such that said cassette may be inserted obliquely into said housing and defining at the lower portion of said cavity an opening that is narrower than said given spacing of said cassette such that the opposing major walls of said cassette will strike the front surface and back surface of said connector housing adjacent the bottom of said cavity,

said connector further including a plurality of electrical spring contacts (22) supported by said housing and extending into said cavity adjacent said housing bottom surface, a portion of each of said contacts lying upwardly of said narrower opening of said cavity, said contacts being arranged to respectively deflectably engage the terminals of said cassette when said cassette major walls strike said front and back housing surfaces, said housing including a latching member (23, 23'B, 23'C) adapted to cooperatively latchingly engage said latching element on said cassette upon rotation of said cassette within said housing cavity on said electrical contacts from said initial oblique insertion position to a latching position.

6. An electrical connector assembly according to Claim 5, wherein said back surface is substantially perpendicular to said bottom surface and said front surface is oblique relative to said bottom surface.

7. An electrical connector assembly according to Claim 6, wherein said electrical contacts project cantileveredly into said cavity, said contacts being supported by said back surface.

**Patentansprüche**

1. Eine elektrische Verbinderanordnung mit:

einer Kassette (10) mit einer Vielzahl von von außen zugänglichen elektrischen Anschlüssen (11) und mit einem von einem Abschnitt der Kassette nach außen verlaufenden im allgemeinen L-förmigen Vorsprung (12'), wobei eine Erhebung (12'A) am oberen Abschnitt des L-förmigen Vorsprunges angeordnet ist, und

einem elektrischen Verbinder mit einem Gehäuse (20) zur gesicherten Aufnahme der Kassette, wobei das Gehäuse einen Hohlraum zur Aufnahme der Kassette und eine Vielzahl von in dem Gehäusehohlraum angeordneten und so ausgerichteten elektrischen Federkontakten (22) aufweist, daß sie bei Einsetzen der Kassette mit deren Anschlüssen (11) in Anlage gelangen, das Gehäuse in einer den Hohlraum begrenzenden Innenwand eine Ausnehmung (23') aufweist, die so bemessen ist, daß sie den Fußabschnitt des L-förmigen Abschnittes aufnimmt, und das Gehäuse ein Riegelglied (23'B, 23'C) zur verriegelnden Anlage an der Erhebung auf dem L-förmigen Vorsprung bei Einsetzen der Kassette in den Verbinder aufweist.

2. Eine elektrische Verbinderanordnung wie in Anspruch 1 beansprucht, wobei der Hohlraum eine Aussparung aufweist, die in ihren Abmessungen vom Boden des Hohlraumes ausgehend absatzweise zunimmt.

3. Eine elektrische Verbinderanordnung wie in Anspruch 1 oder Anspruch 2 beansprucht, wobei der Hohlraum so geformt ist, daß er die Kassette schräg liegend im Hohlraum aufnimmt, und die verriegelnde Anlage bei einer Bewegung der Kassette in eine Lage derart, daß zwei im wesentlichen zueinander parallele und sich gegenüberliegende Hauptwände der Kassette senkrecht zu der Bodeninnenfläche des Hohlraumes stehen, erfolgt.

4. Eine elektrische Verbinderanordnung wie in Anspruch 3 beansprucht, wobei die Ausnehmung eine Führungsnut (23'A) zum schrägen Einsetzen der Kassette in den Hohlraum und eine entsprechende Nut (23'B) zum Verriegeln der Erhebung bei einer Bewegung der Kassette in eine Lage derart aufweist, daß zwei im wesentlichen zueinander parallele und sich gegenüberliegende Hauptwände der Kassette senkrecht zu der Bodeninnenfläche der Kassette stehen.

5. Eine elektrische Verbinderanordnung aus:

einer Kassette (10) mit zwei im wesentlichen zueinander parallelen und sich gegenüberliegenden Hauptwänden die um einen gegebenen Abstand auseinanderliegen, einer quer zwischen den beiden Hauptwänden verlaufenden Bodenwand, und einer Vielzahl von in der Kassette enthaltenen elektrischen Anschlüssen (11), die von außen durch die Bodenwand zugänglich sind, und einem Verriegelungselement (12, 12', 12'A) auf der Kassette;

und einem elektrischen Verbinder (5) zur gesicherten Aufnahme der Kassette, wobei der Verbinder ein Gehäuse (20) enthält, des Gehäuse eine Rückseite, eine in einem Abstand von dieser liegende Vorderseite und eine Bodenseite enthält, die Rück-, die Vorder- und die Bodenseite einen Hohlraum zur Aufnahme der Kassette umschließen, die Vorder- und die Rückseite zueinander konvergieren und dabei eine Aussparung am oberen Abschnitt des Hohlraumes umschließen, der breiter als das vorgegebene Maß der Kassette ist, so daß diese schräg in das Gehäuse eingeführt werden kann und am unteren Abschnitt des Hohlraumes eine Aussparung umschließt, die schmaler als das vorgegebene maß der Kassette ist derart, daß die sich gegenüberliegenden Hauptwände der Kassette an der Vorder- und Rückseite des Verbindergehäuses am Boden des Hohlraumes anschlagen,

wobei der Verbinder weiter eine Vielzahl von an dem Gehäuse abgestützten und an der Gehäusebodenfläche in den Hohlraum hineinragenden elektrischen Federkontakten (22) enthält, ein Abschnitt von jedem der Kontakte oberhalb der schmaleren Aussparung des Hohlraumes liegt, die Kontakte so ausgebildet sind, daß sie an den Anschlüssen der Kassette durchbiegunsfähig anliegen, wenn deren Hauptwände an der Gehäusevorder- und -rückwand anschlagen, das Gehäuse ein Verriegelungsglied (23, 23'B, 23'C) enthält, das das Verriegelungsglied an der Kassette bei deren Drehung in dem Gehäusehohlraum an den elektrischen Kontakten von einer schrägen Einführungslage bis in eine Verriegelungslage zusammenwirkend verriegelnd erfaßt.

6. Eine elektrische Verbinderanordnung nach Anspruch 5, wobei die Rückseite im wesentlichen senkrecht zum Boden und die Vorderseite schräg zum Boden liegt.

7. Eine elektrische Verbinderanordnung nach Anspruch 6, wobei die elektrischen Kontakte freischwebend in den Hohlraum hineinragen und von der Rückseite abgestützt werden.

## Revendications

1. Agencement de connecteur électrique, comprenant:

une cassette (10) ayant une pluralité de bornes électriques (11) accessibles de l'extérieur et comportant une saillie (12') globalement en forme de L s'étendant vers l'extérieur depuis une partie de ladite cassette, une nervure (12'A) étant disposée de façon contiguë de la partie supérieure de ladite saillie en L; et

un connecteur électrique comprenant un carter (20) pour recevoir fermement ladite cassette, ledit carter ayant une cavité interne pour recevoir ladite cassette et une pluralité de contacts électriques (22) à ressorts disposés dans ladite cavité du carter et agencés dans celle-ci pour venir contre les bornes (11) de ladite cassette au moment où la cassette est introduite dans celle-ci, ledit carter ayant un évidement (23') dans une paroi interne définissant ladite cavité, ledit évidement ayant des dimensions appropriées pour recevoir la partie basale de ladite saillie en forme de L, ledit carter ayant un organe de verrouillage (23'B, 23'C) pour réaliser un verrouillage en s'enclenchant sur ladite nervure située sur ladite saillie en L lorsque ladite cassette est introduite sur ledit connecteur.

2. Agencement de connecteur électrique selon la revendication 1, dans lequel ladite cavité a une ouverture qui s'agrandit progressivement depuis le fond de la cavité.

3. Agencement de connecteur électrique selon la revendication 1 ou la revendication 2, dans lequel ladite cavité a une configuration lui permettant de recevoir ladite cassette introduite obliquement dans ladite cavité, et dans lequel ledit enclenchement de verrouillage s'effectue quand ladite cassette vient dans une position telle que deux parois principales opposées sensiblement parallèles de la cassette sont perpendiculaires à la surface interne du fond de ladite cavité.

4. Agencement de connecteur électrique selon la revendication 3, dans lequel ledit évidement comporte une rainure de guidage (23'A) pour introduire la cassette, obliquement dans ladite cavité, et une rainure d'accouplement, (23'B) pour verrouiller ladite nervure lorsque ladite cassette vient dans une position telle que deux parois principales opposées sensiblement parallèles de la cassette sont perpendiculaires à la surface interne du fond de ladite cavité.

5. Agencement de connecteur électrique comprenant:

une cassette (10) ayant deux parois principales opposées sensiblement parallèles espacées par un espacement donné, une paroi inférieure s'étendant transversalement entre lesdites deux parois principales opposées et une pluralité de bornes électriques (11) contenues dans ladite cassette qui sont accessible de l'extérieur par l'intermédiaire de ladite paroi inférieure, et un élément de verrouillage (12, 12', 12'A) présent sur ladite cassette; et

un connecteur électrique (5) pour recevoir fermement ladite cassette, ledit connecteur comprenant un carter (20), le carter ayant une surface postérieure, une surface antérieure espacées de ladite surface postérieure et une surface inférieure, lesdites surfaces postérieure, antérieure et inférieure définissant une cavité pour recevoir ladite cassette, ladite surface antérieure et ladite surface postérieure convergeant l'une vers l'autre et définissant de ce fait, au niveau de la partie supérieure de ladite cavité, un ouverture qui est plus large que l'espacement donné de ladite cassette, de façon que ladite cassette puisse être introduite obliquement dans ledit carter, et définissant, au niveau de la partie inférieure de ladite cavité, une ouverture qui est plus ètroite que ledit espacement donné de ladite cassette, de façon que les parois principales opposées de ladite cassette heurtent la surface antérieure et la surface postérieure dudit carter du connecteur au voisinage immédiat du fond de ladite cavité,

ledit connecteur comprenant en outre une pluralité de contacts électriques (22) à ressorts, supportés par ledit carter et s'étendant jusque dans ladite cavité au voisinage immédiat de ladite surface inférieure du carter, une partie de chacun desdits contacts s'étendant vers le haut de ladite ouverture plus étroite de ladite cavité, lesdits contacts étant agencés pour venir respectivement, par fléchissement, contre les bornes de ladite cassette quand lesdites parois principales de la cassette heurtent lesdites surfaces antérieure et postérieure du carter, ledit carter comportant un organe de verrouillage (23, 23'B, 23'C) conçu pour coopérer avec ledit élément de verrouillage présent sur la cassette et réaliser par enclenchement avec celui-ci un verrouillage lors de la rotation de ladite cassette, présente à l'intérieure de ladite cavité du carter sur lesdits contacts électriques, depuis ladite position initiale oblique d'introduction jusqu'à une position de verrouillage.

6. Agencement de connecteur électrique selon la revendication 5, dans lequel ladite surface postérieure est sensiblement perpendiculaire à ladite surface inférieure, et ladite surface antérieure est oblique par rapport à ladite surface inférieure.

7. Agencement de connecteur électrique selon la revendication 6, dans lequel lesdits contacts électriques dépassent en porte-à-faux dans ladite cavité, lesdits contacts étant supportés par ladite surface postérieure.

FIG. IA  FIG. IB

FIG. 2

FIG. 3

FIG. 4

FIG. 5

FIG. 6

FIG. 7

FIG. II

FIG. 8

FIG. 10

20

FIG. 9

10

12'

23'